# EUROPEAN PATENT SPECIFICATION

(11) **EP 2 977 206 B1**
(45) Date of publication and mention of the grant of the patent: **07.11.2018**
(21) Application number: 13878914.4
(22) Date of filing: 22.03.2013
(51) Int. Cl.: B41F 15/42, B41F 15/08, H05K 3/34, H05K 3/12

(54) **SCREEN PRINTING MACHINE**
SIEBDRUCKMASCHINE
MACHINE DE SÉRIGRAPHIE

(43) Date of publication of application: 27.01.2016
(73) Proprietor: FUJI Corporation, Chiryu Aichi (JP)
(72) Inventor: MIZUNO Manabu, Chiryu-shi Aichi 472-8686 (JP); SUZUKI Hiromi, Chiryu-shi Aichi 472-8686 (JP); HACHISUKA Koji, Chiryu-shi Aichi 472-8686 (JP)
(74) Representative: Grünecker Patent- und Rechtsanwälte PartG mbB
(86) International application number: PCT/JP2013/058277
(87) International publication number: WO 2014/147812

(56) References cited:
- JP-A- H07 132 585
- JP-A- H07 195 658
- JP-A- H11 348 232
- JP-A- 2001 315 298
- JP-A- 2003 191 435
- JP-A- 2010 076 324
- US-A- 5 996 487
- US-A- 6 112 656
- US-A1- 2004 108 368

## Description

### Technical Field

The present invention relates to a screen printer.

### Background Art

The prior art which is shown in PTL 1 is known as a one type of screen printer. As shown in Fig. 1 in PTL 1, the screen printer is provided with a squeegee 17 (squeegee member) which is provided such that the pressing force is variable according to a command value, and performs solder paste screen printing by sliding the squeegee 17 on a mask 12 (mask plate) that is positioned in the printing area of a circuit board 10. As shown in Figs. 8 to 10 in PTL 1, a screen printer is disclosed with a configuration where an area in which the same printing pressure is applied on the mask plate 12 is divided, and a pressing parameter is set in each partition. In this case, the pressing parameter includes air pressure. The screen printer can be set so as be partitioned into an approach run portion and a printing portion, partitioned by variation of mask thicknesses, or partitioned by the height variation of a printed circuit board.
PTL 2 discloses solder paste printing apparatus and method wherein when solder paste passes through a first gap located between a pressurizing member and a printing mask during solder paste printing, a pressure directed toward the printing mask is applied from the pressurizing member to the solder paste.
PTL 3 discloses a creamed-solder printing machine for printing a creamed solder on a printed circuit board, including a screen having a plurality of holes, a squeegee which prints the creamed solder on the printed circuit board through the holes of the screen, a frame which supports the squeegee such that the squeegee is movable toward, and away from, the screen, and an elastic member which is provided between the frame and the squeegee and which produces a biasing force to bias the squeegee in a direction toward the screen.

### Citation List

### Patent Literature

PTL 1: JP-A-2010-143176
PTL 2: US 2004/108368 A1
PTL 3: US 6 112 656 A

### Summary of Invention

### Technical Problem

In the screen printer which is described in PTL 1 described above, although there are cases in which different air pressure is applied in each partition, the same air pressure is applied within the same partition. However, even if a predetermined air pressure is applied within the same partition, there is a problem in that actual printing pressure which is applied on a circuit board 10 by a squeegee 12 is varied within a printing area for screen printing caused by the state of the circuit board 10 (form (presence or absence of a cutout notch or the like), pattern form, and component mounting state), back up state of the circuit board 10, or the like.

Since the invention is carried out in order to solve the problem described above, an object thereof is to suppress variation in actual printing pressure within a printing area for screen printing in a screen printer that is caused by the state of a circuit board, a back-up state of the circuit board, or the like.

### Solution to Problem

In order to solve the problem described above, according to this invention there is provided a screen printer according to claim 1.

### Brief Description of Drawings

[Fig. 1] Fig. 1 is a side surface view illustrating an embodiment of a screen printer according to the invention.
[Fig. 2] Fig. 2 is a block view illustrating a control device which configures the screen printer that is illustrated in Fig. 1.
[Fig. 3] Fig. 3 is a flow chart of a program (test printing) which is executed in the control device that is illustrated in Fig. 2.
[Fig. 4] Fig. 4 is a view illustrating an example of control data.
[Fig. 5] Fig. 5 is a view illustrating an example of the control data in an upper stage, a view illustrating printing pressure data in an intermediate stage when screen printing is carried out on a circuit board which is illustrated in a lower stage, and an upper surface view of the circuit board which becomes a screen printing target and a clamp section in the lower stage.
[Fig. 6] Fig. 6 is a view illustrating the printing pressure data which is illustrated in Fig. 5 and printing pressure inversion data thereof.
[Fig. 7] Fig. 7 is a view illustrating an example of corrected control data.
[Fig. 8] Fig. 8 is a view illustrating control data of the other of a pair of printing squeegees which is generated by inverting control data of one printing squeegee left to right.
[Fig. 9] Fig. 9 is a flow chart of a program (actual printing) which is executed in the control device that is illustrated in Fig. 2.

### Description of Embodiments

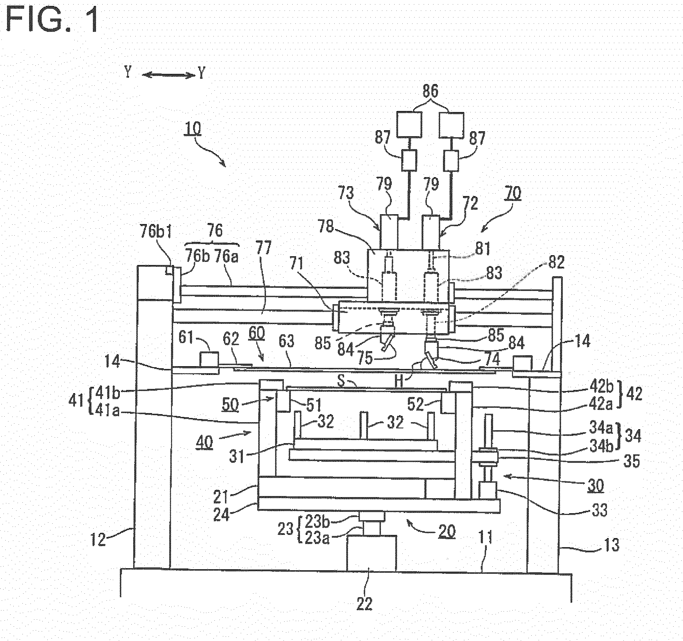

An embodiment of a screen printer according to the invention will be described below. Fig. 1 is a side surface view of the screen printer. As shown in Fig. 1, a screen printer 10 is provided with a board lifting and lowering device 20, a back-up device 30, a clamp device 40, a board conveyance device 50, a mask device 60, a squeegee device 70, and a control device 90.

The board lifting and lowering device 20 is provided on the upper surface of a base 11. The board lifting and lowering device 20 is provided with a main table 21, a main table servo motor 22, a ball screw section 23, and a nut side table 24.

The main table 21 is formed in a rectangular plate form, is disposed in parallel above the base 11, and is lifted in the vertical direction with respect to the upper surface of the base 11. The nut side table 24 which is formed in the rectangular plate form is disposed so as to abut a lower surface of the main table 21. A nut 23b of the ball screw section 23 is fixed to the nut side table 24.

The ball screw section 23 is a ball screw which is formed of a screw axis 23a, a nut 23b, and a ball, which is not shown in the drawings, that has a rolling motion between the screw axis 23a and the nut 23b. The lower end of the screw axis 23a communicates with a driving axis of the main table servo motor 22 which is fixed to the upper surface of the base 11. When a driving axis of the main table servo motor 22 rotates about the axis, the nut 23b moves along the axial direction (vertical direction) of the screw axis 23a due to the screw axis 23a also integrally rotating about the axis. Thereby, the nut side table 24, and thus the main table 21, moves in the vertical direction. A main table encoder (not illustrated) is provided in the main table servo motor 22.

The back-up device 30 is provided with a back-up table 31, a plurality of back up pins 32, a back-up table servo motor 33, a ball screw section 34, and a nut side table 35.

The back-up table 31 is formed in a rectangular plate form. The back-up table 31 is disposed in parallel above the main table 21, and relatively moves in the vertical direction with respect to the main table 21. A plurality of the back-up pins 32 are disposed on the upper surface of the back-up table 31. The back-up pin 32 supports a circuit board S from below. The back-up table 31 is disposed on the upper surface of the nut side table 35 which is formed in a rectangular plate form. A nut 34b of the ball screw section 34 is fixed to the nut side table 35.

The ball screw section 34 is a ball screw which is formed of a screw axis 34a, a nut 34b, and a ball, which is not shown in the drawings, that has a rolling motion between the screw axis 34a and the nut 34b. The lower end of the screw axis 34a communicates with a driving axis of a back-up table servo motor 33 which is fixed to the upper surface of the nut side table 24. When a driving axis of the backup table servo motor 33 rotates about the axis, the nut 34b moves along the axial direction (vertical direction) of the screw axis 34a due to the screw axis 34a also integrally rotating about the axis. Thereby, the nut side table 35, and thus the backup table 31, moves in the vertical direction. A back up table encoder (not illustrated) is provided in the back up table servo motor 33.

The clamp device 40 is provided with a fixed clamp 41 and a movable clamp 42. The fixed clamp 41 is provided with a frame section 41a and a clamp section 41b. The movable clamp 42 is provided with a frame section 42a and a clamp section 42b.

The frame section 41a and the frame section 42a are each formed in a substantially U shape which is open downward. The frame section 41a and the frame section 42a are disposed so as to face each other and interpose the back-up table 31. The frame section 41a is fixed so as to be erected upwardly from one end edge (for example, the front edge) of the main table 21. The frame section 42a is erected upwardly from the other end edge (for example, the back edge) of the main table 21. The frame section 42a is movable in the forward and backward direction (for example, the left and right direction in Fig. 1) by a driving device, which is not shown in the drawings.

The clamp section 41b is formed in a long and narrow plate form, and is fixed to the upper end of the frame section 41a. The clamp section 42b is formed in a long and narrow plate form, and is fixed to the upper end of the frame section 42a. Both clamp sections 41b and 42b are disposed to face each other in parallel, and pinch the circuit board S from both sides so as to clamp the circuit board S.

The board conveyance device 50 is provided with a pair of conveyor belts 51 and 52. The conveyor belts 51 and 52 each extend in the left and right direction (board conveyance direction). The conveyor belt 51 is disposed on the rear surface upper edge of the frame section 41a of the fixed clamp 41, and the conveyor belt 52 is disposed on the front surface upper edge of the frame section 42a of the movable clamp 42. The pair of conveyor belts 51 and 52 face each other in parallel. The circuit board S is held between the pair of conveyor belts 51 and 52. The circuit board S is conveyed by the pair of conveyor belts 51 and 52 from the left side (upstream side) to the right side (downstream side).

The mask device 60 is provided with a frame 61, a mesh 62, and a screen mask 63. The mask device 60 is disposed above the clamp device 40. The frame 61 is formed in a rectangular frame form. The mesh 62 is formed in a rectangular frame form. The mesh 62 is disposed inside the frame of the frame 61. The screen mask 63 is formed in a rectangular thin plate form. The screen mask 63 is tensioned on the mesh 62. Multiple pattern holes (which are omitted in the drawings) are formed in the screen mask 63. The pattern holes are disposed in a predetermined pattern according to a printing position on the circuit board S.

The mask device 60 is supported by a mask holding base 14. The mask holding base 14 is a rectangular frame body, and the frame 61 is positioned so as to be fixed by being placed thereupon. In addition, solder paste H is supplied by a solder supply device, which omitted in the drawings, in a paste form onto the screen mask 63. The mask holding base 14 is fixed to a pair of frames 12 and 13 which are erected from the base 11 upward. The board lifting and lowering device 20, the back-up device 30, the clamp device 40, the board conveyance device 50, the mask device 60, and the squeegee device 70 are disposed between the frame 12 and the frame 13.

As shown in Fig. 1, the squeegee device 70 is provided with a slide 71, a first lifting device 72 and a second lifting device 73 held by the slide 71, a first printing squeegee 74 held by the first lifting device 72, a second printing squeegee 75 held by the second lifting device 73, and a slide feeder 76 which feeds the slide 71 in the Y axis direction. The slide feeder 76 includes a ball screw mechanism 76a and a squeegee servo motor 76b as a driving source. The ball screw mechanism 76a converts rotation of the squeegee servo motor 76b into linear motion so that the slide 71 is moved in the Y direction. In addition, the squeegee servo motor 76b is controlled by the control device 90.

The movement of the slide 71 is guided by guide rails 77 which extend in the Y axis direction on both sides of the slide 71, and guide blocks, which are omitted from the drawings, which are fixed to each side surface of the slide71 respectively, and which are respectively fitted in the each guide rail 77 so as to be relatively movable on the each guide rail 77. The guide rail 77 is mounted between the frame 12 and the frame 13 .

A squeegee encoder 76b1 is provided in the squeegee servo motor 76b. The squeegee encoder 76b1 detects positions of the first and second printing squeegees 74 and 75 in the Y axis direction, and the detection result is output to the control device 90. Here, a distance measuring sensor which uses infrared rays or the like may be used as the sensor which detects the position.

A frame 78 which is formed in a substantial U shape that is open downward is fixed to the slide 71. The frame 78 is provided with a pair of a side wall and a ceiling. The first lifting device 72 and the first printing squeegee 74, and the second lifting device 73 and the second printing squeegee 75 are provided symmetrically with respect to a plane which is orthogonal to the movement direction (sliding direction) of the squeegee device 70 in the frame 78 which is fixed to the slide 71. The lifting devices 72 and 73 and the printing squeegees 74 and 75 have the same configurations, and the first lifting device 72 and the first printing squeegee 74 are described as representative examples.

As shown in Fig. 1, the first lifting device 72 has a cylinder section 79 which encloses air, and a piston section 81 which slides inside the cylinder section 79 by the pressure of the enclosed air. A guide rod 82 is fixed to the lower end section of the piston section 81, and lifting of the first printing squeegee 74 is guided by the guide rod 82 being slidably fitted in a guide tube 83 which is erected on the slide 71. A squeegee holding member 84 is detachably attached to the lower end of the first lifting device 72. The squeegee holding member 84 holds the first printing squeegee 74. The first printing squeegee 74 is provided with a squeegee main body section which is formed in a rectangular thin plate form.

Furthermore, a pressure sensor 85, which measures printing pressure that is applied on the circuit board S by the first printing squeegee 74 according to the pressing force of the printing squeegee 74, is provided in the first lifting device 72. A detection result of the pressure sensor 85 is output to the control device 90. For example, a load cell is used as the pressure sensor 85. The pressure sensor 85 is desirably provided in the guide rod 82. The pressure sensor 85 may not be provided on the squeegee device 70 side, and may be provided on the back up device 30 side. For example, it is sufficient if the pressure sensor 85 is provided in the back up pin 32 or the back-up table 31.

The cylinder section 79 communicates with the air pressure supply source 86, and air supply is adjusted using a regulator 87 which is provided between the cylinder section 79 and the air pressure supply source 86. In addition, the air pressure supply source 86 may be an air pump, an accumulator, a compressor, or the like. Here, the regulator 87 is controlled by the control device 90. Thereby, the first printing squeegee 74 is able to variably control pressing force according to a command value from the control device 90.

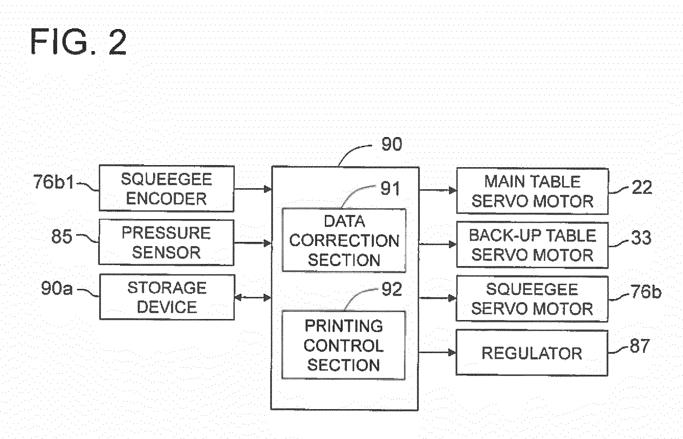

The control device 90 performs control for screen printing using the screen printer 10. Screen printing is applying solder paste by sliding the first printing squeegee 74 (or 75) on the screen mask 63 which is positioned in the printing area of the circuit board S. As shown in Fig. 2, the control device 90 is connected by the squeegee encoder 76b1, the pressure sensor 85, each servo motor 22, 33, and 76b, the regulator 87 described above and a storage device 90a. In addition, the control device 90 has a microcomputer (not illustrated), and the microcomputer is provided with an input and output interface, a CPU, a RAM, and a ROM (all of which are omitted from the drawings) which are each connected via a bus.

The control device 90 is provided with a data correction section 91 and a printing control section 92. The data correction section 91 corrects control data which illustrates a relationship between the positions of the printing squeegees 74 and 75 in at least a region of the printing area (that is all regions or at least a region of the printing area) and the command value based on the printing pressure which is measured across the entirety of the region and the target value of the printing pressure which is set in advance. The printing control section 92 controls screen printing based on the corrected control data.

Basic operation of the screen printer 10 which is configured as above will be described. In a case where solder paste H in a paste form as a printing agent is printed on the circuit board S using the screen printer 10 in the present embodiment, the screen mask 63 is positioned on the fixed mask holding base 14, and the solder paste H is placed on the screen mask 63 using the solder supply device.

In the squeegee device 70, the slide 71 is positioned on one end in the Y axis direction within the printing area of the screen mask 63, and either of the first printing squeegee 74 and the second printing squeegee 75 is positioned at an upper end. Then, the circuit board S is conveyed to a predetermined position by the board conveyance device 50. The back-up device 30 is raised, and the circuit board S which is at the predetermined position is raised to the position that is substantially the same surface as the upper surface of the clamp sections 41b and 42b of the clamp device 40 (The circuit board S is raised somewhat higher than the upper surface of the clamp sections 41b and 42b). The movable clamp 42 of the clamp device 40 is moved, and the circuit board S is held by the clamp sections 41b and 42b. The board lifting and lowering device 20 is raised, and the upper surface of the circuit board S is held so as to be positioned at the printing position which comes into contact with the lower surface of the screen mask 63.

Next, the regulator 87 is adjusted, the first printing squeegee 74 is lowered by the first lifting device 72, and the lower end of the first printing squeegee 74 comes to be in a state of coming into contact with the upper surface of the screen mask 63. At this time, the second printing squeegee 75 remains in a state of being held on the upper end. Next, as shown in Fig. 1, the squeegee servo motor 76b is moved, the slide 71 is moved in the Y axis direction (toward the left in Fig. 1), and the first printing squeegee 74 and the second printing squeegee 75 are moved in the Y axis direction. At this time, the lower end section of the first printing squeegee 74 slides while in contact with the surface of the screen mask 63, the solder paste H which is placed on the screen mask 63 is pushed into a pattern hole which is formed on the circuit board S, and printing is performed on the surface of the circuit board S.

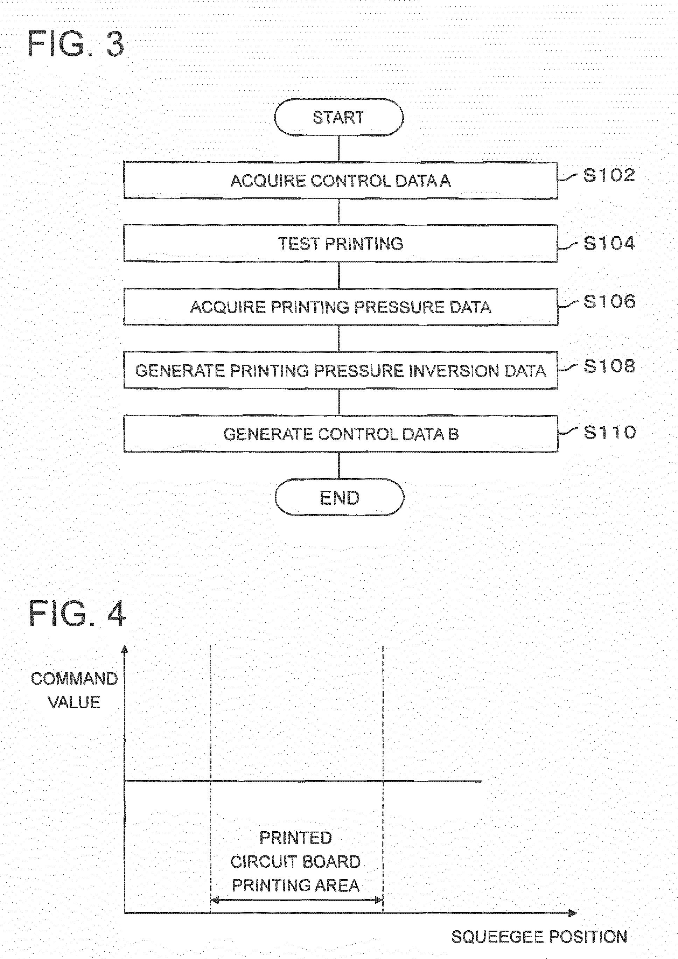

Furthermore, an example of a test printing operation of the screen printer 10 which is described above will be described using the flow chart that is illustrated in Fig. 3. In step S102, the control device 90 acquires (reads out) control data for test printing from the storage device 90a. Control data A for test printing is data which illustrates a relationship between the squeegee position (position in the Y axis direction) and the command value. The command value is a control command value for generating a desired air pressure. As shown in Fig. 4, for example, the control data A for test printing has a predetermined command value. Here, as will be described later, the control data A for test printing may use correction based on a printing environment which includes at least one of the form of the circuit board S, bending rigidity of the circuit board S, and the holding state in the screen printer.

In step S104, the control device 90 executes test printing based on the control data A for test printing. In detail, pressing force of the squeegee device 70 is adjusted by controlling the regulator 87 such that the printing pressure becomes a target value of air pressure corresponding to the command value of the control data. That is, the control device 90 performs screen printing at the pressing pressure of the air pressure value corresponding to the predetermined command value which is illustrated in Fig. 4.

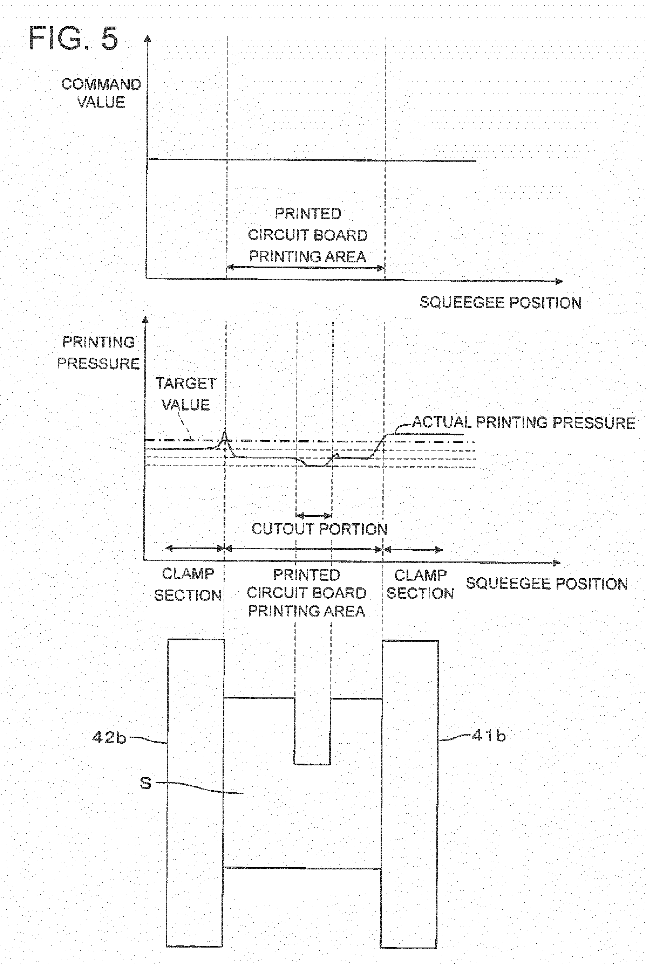

In step S106, the control device 90 acquires printing pressure data. The printing pressure data is data on printing pressure which is measured by the pressure sensor 85 across the entire printing area, and is data which illustrates the relationship between the squeegee position and the measured printing pressure (actual printing pressure). For example, as shown in Fig. 5, in a case where the pressing force (target value for pressure) which corresponds to the predetermined command value is applied, there are cases where the actual printing pressure deviates from the target value for pressure, that is, a case where the actual printing pressure is not applied as the command value.

An example of this case will be described. The printing squeegee 74 (75) comes into contact with the clamp section 41b (42b) at the print start time, but comes into contact with the circuit board S when printing proceeds. At this time, since the length in the longitudinal direction of the clamp section 41b (42b) is set to the maximum placeable circuit board S, there are cases where the length in the longitudinal direction of the circuit board S is shorter than the clamp section 41b (42b) (refer to the lower stage in Fig. 5). In this case, the contact length in the circuit board S is short in comparison to the clamp section 41b, and the actual printing pressure is reduced. Here, a case where there is a cutout notch in the circuit board S (refer to the lower stage in Fig. 5) is the same.

In addition, in a case where the upper surface of the circuit board S is set so as to become higher than the upper surface of the clamp sections 41b and 42b in the circuit board S which is held by the clamps 41 and 42, when the printing squeegee 74 (75) rides over the clamp section 41b (42b), the reaction force makes the printing squeegee 74 (75) be lifted. In this case, the actual printing pressure increases.

In addition, even in a case where the bending rigidity of the circuit board S is different along the direction of the squeegee position (for example, in a case where a component is already mounted on the lower surface, in a case where the arrangement state of a copper foil pattern is different, and the like), since the reaction force which makes the printing squeegee 74 (75) be lifted is different, the actual printing pressure is different according to the squeegee position. In addition, whether or not the circuit board S is supported by the back-up pin 32, since the reaction force which makes the printing squeegee 74 (75) be lifted is different, the actual printing pressure is different according to the squeegee position.

For example, the printing pressure data which is illustrated in the intermediate stage of Fig. 5 is data of when the printing squeegee 74 prints from the right side to the left side in Fig. 1. Overall, the actual printing pressure is smaller than the target value. When the printing squeegee 74 rides over the circuit board S from the initial clamp section 42b, the actual printing pressure instantly increases. When the printing squeegee 74 rides over the circuit board S, since the contact length shortens, the actual printing pressure is reduced in comparison to the initial clamp section 42b. Furthermore, when the printing squeegee 74 reaches the cutout notch section of the circuit board S, since the contact length is further shortened, the actual printing pressure is further reduced. When the printing squeegee 74 passes through the cutout notch section of the circuit board S, since the contact length returns to the value before the cutout portion, the actual printing pressure increases, and returns to the amount before the cutout portion. Then, as the printing squeegee 74 transitions from the circuit board S to the last clamp section 41b, the actual printing pressure increases.

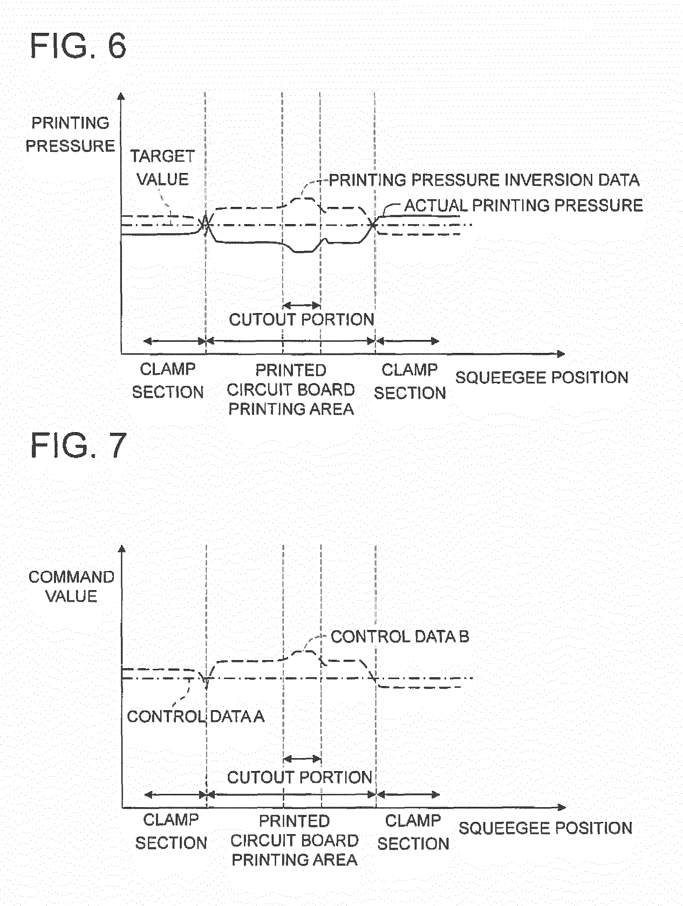

In step S108, the control device 90 generates printing pressure inversion data from the printing pressure data which is acquired in step S106. In detail, the printing pressure inversion data is generated by vertically inverting the printing pressure data with respect to the target value. The printing pressure inversion data is illustrated in Fig. 6. Furthermore, in step S110, the control device 90 generates control data B from the printing pressure inversion data which is generated in step S108. In detail, since the printing pressure inversion data is printing pressure, the control data B is generated by conversion to a control command value which is equivalent to air pressure that is to be generated. The control data is illustrated in Fig. 7. In other words, the control device 90 corrects the control data based on a pressure characteristic which illustrates the amount of variation of the printing pressure with respect to the amount of correction of the command value. The printing characteristic is a conversion coefficient of the printing pressure with respect to the command value. In a case where the command value and the printing pressure are the same value, the conversion coefficient thereof is 1.

In this manner, it is possible to generate the control data B of the one printing squeegee 74 out of the pair of printing squeegees 74 and 75 by the processes from step S102 to step S110 described above. Then, the control device 90 performs screen printing which is described above using the control data B that is generated in such a manner.

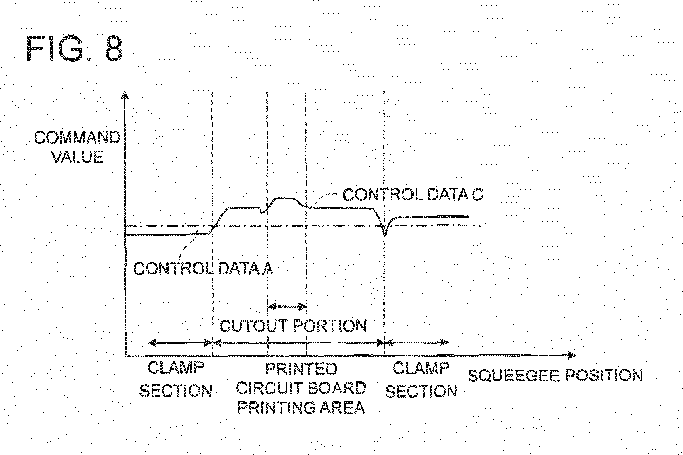

Here, in the same manner as the control data B of the one printing squeegee 74, it is possible to generate control data C of the other printing squeegee 75 by the processes from step S102 to step S110 described above. In addition, it is also possible to generate the control data C of the other printing squeegee 75 utilizing the control data B of the one printing squeegee 74 which is inverted left to right. At this time, in step S102 described above, it is sufficient if the control data B which is inverted left to right (the control data C) is used in place of the predetermined command value (the control data A) (refer to Fig. 8). In addition, in step S110 described above, the value of the printing pressure inversion data described above may be added to the control data C and corrected.

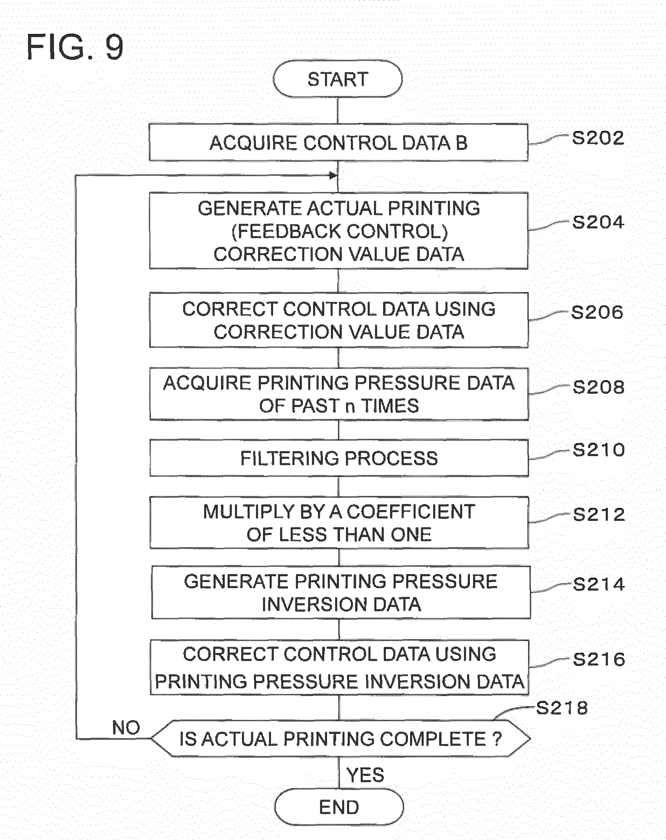

Furthermore, an example of actual printing of the screen printer 10 which is described above will be described using the flow chart that is illustrated in Fig. 9. In step S202, the control device 90 acquires the control data B that is generated in test printing (or the control data C) from the storage device 90a. In step S204, the control device 90 actually executes screen printing. At this time, screen printing is executed based on the control data B (or the control data C) acquired in step S202. At this time, the control device 90 performs feedback control. In detail, the control device 90 performs feedback control in which the measured printing pressure (related to the squeegee position across the printing area) is corrected to the command value so as to be accommodated within a permissible range with respect to the target value during execution of squeegee printing. The correction value is a correction value of the command value, and is a value which is correlated to the difference between the target value of the printing pressure and the measured printing pressure. Furthermore, in step S204, the control device 90 generates correction value data which is a relationship between the correction value of the command value in step S202 and the squeegee position, and stores the data in the storage device 90a. The correction data is generated in each circuit board S. In addition, the control device 90 relates the measured printing pressure and the squeegee position and stores in the storage device 90a.

In step S206, the control device 90 corrects the control data using previously generated correction value data. That is, the control data is corrected based on a deviation of the command value in the control data and the correction value of the command value in the feedback control. That is, at each squeegee position, the command value of the control data is corrected based on the deviation of the command value in the control data and the correction value of the correction value data.

Next, the control device 90 is used in correction of control data by statistically processing the printing pressure data by the processes from step S208 to step S212. The control device 90 acquires printing pressure data of the past n times (n is two or more (plurality of times), for example, 10) from the storage device 90a (step S208), and performs a filtering process (step S210). The filtering process removes abnormal variance which is included in the printing pressure based on the measured printing pressure when screen printing is performed a plurality of times. In detail, for example, printing pressure data is removed which is out of the predetermined range with an average value of a past n times as the center, or which is out of the standard deviation of the past n times. At this time, the entire printing pressure data may be removed, or a portion of the pressure data may be removed.

In step S212, in the control device 90, a coefficient which is set to less than one (for example, 0.5) is multiplied by a difference between the average value and the target value of the printing pressure (printing pressure data) which is measured when screen printing is performed a plurality of times (for example 10 times). Thereby, it is possible to suppress correction beyond necessity, thus it is possible to suppress correction from fluctuating.

In step S214, the control device 90 generates printing pressure inversion data using a product of step S212. Since the product results from multiplying the coefficient by the difference between the average value and the target value, it is possible to obtain printing pressure inversion data if the positive and the negative of the difference are inverted.

Furthermore, in step S216, the control device 90 corrects control data using the printing pressure inversion data which is generated in step S214. In detail, since the printing pressure inversion data is printing pressure, the control data is generated by converting to a control command value which is equivalent to air pressure that is to be generated. The control data is corrected by adding the control data which is corrected in step S206 described above to the generated control data. The processes from step S204 to step S216 described above are repeatedly executed until actual printing is complete (until "YES" is determined in step S218).

According to the present embodiment, the data correction section 91 corrects control data which illustrates a relationship between the positions of the squeegees 74 and 75 in the printing area of the circuit board S and the command values based on the printing pressure which is measured across the entire printing area and the target value of the printing pressure which is set in advance. The printing control section 92 controls screen printing based on the corrected control data. Thereby, screen printing is controlled using control data which is corrected based on the printing pressure which is measured across the entire printing area of the circuit board S and the target value of the printing pressure that is set in advance. That is, it is possible to achieve a fixed printing pressure which is actually applied using a corrected command value by correcting the command value based on the result of a comparison of the target value of the printing pressure which corresponds to the command value and the measured actual printing pressure at each position of the squeegee 74 (or 75). Consequently, it is possible to suppress variations in actual printing pressure within the screen printing area that are caused by the state of the circuit board S, the back-up state of the circuit board S, and the like.

In addition, since printing errors which are regularly occurred due to the set production board type and production state are predicted in advance and are reflected to the control data, errors which are generated during production are only errors that are caused by the states of individual circuit boards S, and printing precision is improved.

Here, in a case where the errors (printing pressure variation) are caused by the contact length of the squeegee, it is desirable for the control data to set the relationship between the contact length and the errors in a database. In addition, in a case where the errors are caused by height such as a level difference of a printed circuit board, it is desirable for the relationship between the height and the errors to be set in a database.

In addition, the data correction section 91 corrects control data based on printing pressure inversion data that reflects the printing pressure which is measured across the entire printing area inverted with respect to the target value (steps S106 to S110). Thereby, it is possible to achieve efficiency of correction of the command value.

In addition, the data correction section 91 corrects the control data based on a pressure characteristic which illustrates the amount of variation of the printing pressure with respect to the amount of correction of the command value (steps S110 and S216). Thereby, it is possible to achieve improved correction precision of the command value. That is, it is possible to clarify the correlation between the command value and the printing pressure (measurement value). There are cases where the command value has the same pressure [N] (or [Pa]) as the measurement value according to the configuration of the squeegee device 70, meanwhile, in a case where a configuration is assumed in which the pressure is varied based on the Z position of the squeegee (position in the vertical direction), it is necessary to convert the pressure to the command value which corresponds to the measurement value. Therefore, using a pressure characteristic in which the command value and the measurement value are associated, both are correlated to each other, and correction of the control data becomes possible.

In addition, the printing control section 92 performs feedback control in which the command value is corrected such that the measured printing pressure is accommodated in a permissible range with respect to the target value during execution of screen printing (step S204), and the data correction section 91 corrects the control data based on deviation between the command value in the control data and the correction value of the command value in the feedback control (step S206). Thereby, it is possible to correct the command value by also taking into account the correction value of the command value in the feedback control, and it is possible to optimize correction of the command value in a lot. Consequently, since the command value is corrected based on the actual printing pressure during printing, it is possible to improve accuracy of the command value in each repetition of production.

In addition, the data correction section 91 corrects the control data based on the printing pressure which is measured during screen printing across a plurality of times (step S208 and S216) . Thereby, it is possible to reflect the latest state during production, that is, to achieve high precision of statistical correction. In addition, it is possible further suppress abnormal errors which are occurred in each individual circuit board S.

In addition, the data correction section 91 has a filtering process section which removes abnormal variation included in the printing pressure based on the printing pressure which is measured during screen printing across a plurality of times (step S210). Thereby, it is possible to achieve high precision of correction by reflecting the latest state by removing abnormal variation.

In addition, the data correction section 91 corrects control data (step S216) based on a product of the difference between the average value of the printing pressure which is measured during screen printing across a plurality of times and the target value, and a coefficient which is set to less than one (step S212). Thereby, it is possible prevent fluctuation and divergence of the corrected command value.

In addition, the screen printer 10 has the pair of printing squeegees 74 and 75 which are opposite to each other in the sliding direction during screen printing, and the printing control section 92 controls screen printing based on the control data which is measured in each of the pair of printing squeegees 74 and 75. Thereby, it is possible to appropriately perform individual printing control corresponding to each printing squeegee 74 and 75.

In addition, the data correction section 91 corrects control data which is set for one of the pair of printing squeegees 74 and 75, and corrects control data which is set for the other of the pair of printing squeegees based on control inversion data which is inverted with respect to the center of the sliding direction of the squeegee in the printing area. Thereby, it is possible to achieve efficiency of production and correction of the control data.

In addition, the data correction section 91 corrects the control data based on the printing environment which includes at least one of the form of the circuit board S, the bending rigidity of the circuit board S, and the holding state in the screen printer 10. Thereby, it is possible to appropriately perform correction of the command value considering various printing pressure variables.

Here, in the embodiment described above, the control device 90 corrects control data relating to the entire printing area using printing pressure which is measured across the entire printing area, but the control data according to at least a region of the printing area may be corrected using the printing pressure which is measured across the entirety of the region. In this case, printing pressure data is acquired which illustrates the relationship between the squeegee position in the region in which the printing pressure is measured (at least a region of the printing area) and the actual printing pressure, and from the printing pressure data, the printing pressure inversion data which corresponds to the measured region may be generated, and the control data which corresponds to the measured region may be generated.

Thereby, the data correction section 91 corrects control data which illustrates the relationship between the positions of the squeegees 74 and 75 in at least a region of the printing area of the circuit board S and the command value based on the printing pressure which is measured across the entirety of the region and the target value of the printing pressure which is set in advance. The printing control section 92 controls screen printing based on the corrected control data. Thereby, screen printing is controlled using control data which is corrected based on the printing pressure which is measured across the entirety of the region of at least a region of the printing area of the circuit board S and the target value of the printing pressure that is set in advance. That is, it is possible to achieve a fixed printing pressure which is actually applied using the corrected command value by correcting the command value based on the result of a comparison of the target value of the printing pressure which corresponds to the command value and the measured actual printing pressure at each position of the squeegee 74 (or 75) in at least a region of the printing area of the circuit board S. Consequently, it is possible to suppress variations in actual printing pressure within the screen printing area that are caused by the state of the circuit board S, the back-up state of the circuit board S, and the like.

In addition, since printing errors which are regularly occurred due to the set production board type and production state are predicted in advance and are reflected to the control data, the errors which are occurred during production are only errors that are caused by the states of individual circuit boards S, and printing precision is improved.

In addition, in the embodiment described above, the squeegee device is configured such that air pressure as the pressing force is applied, but may be configured such that, as the pressing force, biasing force of a biasing member (a spring, rubber, or the like) which is moved so as to be positioned by a ball screw is applied.

In addition, in the embodiment described above, the actual measurement value of the plurality of times is set so as to be subjected to the filtering process, but a plurality of actual measurement values may be set so as to be weighted.

In addition, as the timing at which the printing pressure is measured, in addition to during test printing which is described above (set up change), there are during solder kneading, during a measurement command (an operation dedicated to printing measurement), and during actual printing.

### Reference Signs List

S ... CIRCUIT BOARD, 10 ... SCREEN PRINTER, 11 ... BASE, 12, 13 ... FRAME, 14 ... MASK HOLDING BASE, 20 ... BOARD LIFTING AND LOWERING DEVICE, 21 ... MAIN TABLE, 22 ... MAIN TABLE SERVO MOTOR, 23 ... BALL SCREW SECTION, 23a ... SCREW AXIS, 23b ... NUT, 24 ... NUT SIDE TABLE, 30 ... BACK UP DEVICE, 31 ... BACK UP TABLE, 32 ... BACK UP PIN, 33 ... BACK UP TABLE SERVO MOTOR, 34 BALL SCREW SECTION, 34a ... SCREW AXIS, 34b ... NUT, 35 ... NUT SIDE TABLE, 40 ... CLAMP DEVICE, 41 ... FIXED CLAMP, 41a ... FRAME SECTION, 41b ... CLAMP SECTION, 42 ... MOVABLE CLAMP, 42a ... FRAME SECTION, 42b ... CLAMP SECTION, 50 ... BOARD CONVEYANCE DEVICE, 51, 52 ... CONVEYOR BELT, 60 ... MASK DEVICE, 61 ... FRAME, 62 ... MESH, 63 ... SCREEN MASK (MASK), 70 ... SQUEEGEE DEVICE, 71 ... SLIDE, 72, 73 ... FIRST AND SECOND LIFTING DEVICES, 74, 75 ... FIRST AND SECOND PRINTING SQUEEGEE (SQUEEGEE), 76 ... SLIDE FEEDER, 76a ... BALL SCREW MECHANISM, 76b . . . SQUEEGEE SERVO MOTOR, 76b1 ... SQUEEGEE ENCODER, 77 ... GUIDE RAIL, 78 ... FRAME, 79 ... CYLINDER SECTION, 81 ... PISTON SECTION, 82 ... GUIDE ROD, 83 GUIDE TUBE, 84 ... SQUEEGEE HOLDING MEMBER, 85 ... PRESSURE SENSOR, 86 ... AIR PRESSURE SUPPLY SOURCE, 87 ... REGULATOR, 90 ... CONTROL DEVICE, 90a ... STORAGE DEVICE, 91 ... DATA CORRECTION SECTION, 92 ... PRINTING CONTROL SECTION

## Claims

1. A screen printer which has a squeegee that varies a pressing force during printing operation according to a command value, and which performs solder paste screen printing by sliding the squeegee on a mask positioned in the printing area of a circuit board, comprising:
a pressure sensor which measures the printing pressure applied on the circuit board during printing operation by the squeegee according to the pressing force; and
a printing control section,
**characterized by**
a data correction section which corrects control data that illustrates the relationship between the position of the squeegee and a command value in at least a region of the printing area on the basis of the relationship between the position of the squeegee and the printing pressure measured over the entirety of the region and a target value of the printing pressure that is set in advance,wherein
the printing control section controls screen printing based on the corrected control data.

2. The screen printer according to Claim 1, wherein the data correction section corrects the control data based on printing pressure inversion data that reflects the printing pressure which is measured across the entirety of the region inverted with respect to the target value.

3. The screen printer according to Claim 1 or 2, wherein the data correction section corrects the control data based on a printing characteristic which illustrates the amount of variation of the printing pressure with respect to the amount of correction of the command value.

4. The screen printer according to any one of Claim 1 to 3,
wherein the printing control section performs feedback control during execution of screen printing in which the command value is corrected such that the measured printing pressure is accommodated in a permissible range with respect to the target value, and
the data correction section corrects control data based on deviation between the command value in the control data and the correction value of the command value in the feedback control.

5. The screen printer according to any one of Claim 1 to 4, wherein the data correction section corrects the control data based on the printing pressure which is measured during screen printing across a plurality of times.

6. The screen printer according to Claim 5, wherein the data correction section has a filtering process section which removes abnormal variation included in the printing pressure based on the printing pressure which is measured during screen printing across a plurality of times.

7. The screen printer according to Claim 5 or 6, wherein the data correction section corrects the control data based on a product of the difference between the average value of the printing pressure which is measured during screen printing across a plurality of times and the target value, and a coefficient which is set to less than one.

8. The screen printer according to any one of Claim 1 to 7,
wherein the screen printer has the pair of printing squeegees which are opposite to each other in the sliding direction during screen printing, and
the printing control section controls screen printing based on the control data which is measured in each of the pair of printing squeegees.

9. The screen printer according to Claim 8, wherein the data correction section corrects, based on control inversion data which is generated by inverting control data that is set for one of the pair of printing squeegees, control data of the other of the pair of printing squeegees.

10. The screen printer according to any one of Claim 1 to 9, wherein the data correction section corrects the control data based on the printing environment which includes at least one of the form of the circuit board, the bending rigidity of the circuit board, and the holding state in the screen printer.

## Patentansprüche

1. Siebdrucker, der eine Rakel aufweist, die eine Drückkraft während des Druckvorgangs in Entsprechung zu einem Befehlswert variiert, und der ein Lötpasten-Siebdrucken durch das Schieben der Rakel auf einer in dem Druckbereich einer Leiterplatte positionierten Maske durchführt, umfassend:
einen Drucksensor, der den auf die Leiterplatte während des Druckvorgangs durch die Rakel in Entsprechung zu der Drückkraft ausgeübten Druckdruck misst, und
einen Drucksteuerabschnitt,
**gekennzeichnet durch**
einen Datenkorrekturabschnitt, der Steuerdaten, die die Beziehung zwischen der Position der Rakel und einem Befehlswert in wenigstens einem Abschnitt des Druckbereichs angeben, basierend auf der Beziehung zwischen der Position der Rakel und dem über den gesamten Abschnitt hinweg gemessenen Druckdruck und auf einem zuvor gesetzten Zielwert des Druckdrucks korrigiert,
wobei der Drucksteuerabschnitt das Siebdrucken basierend auf den korrigierten Steuerdaten steuert.

2. Siebdrucker nach Anspruch 1, wobei der Datenkorrekturabschnitt die Steuerdaten basierend auf Druckdruck-Inversionsdaten korrigiert, die den über den gesamten Abschnitt gemessenen Druckdruck invertiert in Bezug auf den Zielwert angeben.

3. Siebdrucker nach Anspruch 1 oder 2, wobei der Datenkorrekturabschnitt die Steuerdaten basierend auf einer Druckkennlinie korrigiert, die die Größe der Variation des Druckdrucks in Bezug auf die Größe der Korrektur des Befehlswerts angibt.

4. Siebdrucker nach einem der Ansprüche 1 bis 3, wobei:
der Drucksteuerabschnitt eine Regelungssteuerung während der Ausführung des Siebdruckens durchführt, in welcher der Befehlswert derart korrigiert wird, dass der gemessene Druckdruck in einem zulässigen Bereich in Bezug auf den Zielwert enthalten ist, und
der Datenkorrekturabschnitt Steuerdaten basierend auf einer Abweichung zwischen dem Befehlswert in den Steuerdaten und dem Korrekturwert des Befehlswerts in der Regelungssteuerung korrigiert.

5. Siebdrucker nach einem der Ansprüche 1 bis 4, wobei der Datenkorrekturabschnitt die Steuerdaten basierend auf dem Druckdruck korrigiert, der während des Siebdruckens mit einer Vielzahl von Wiederholungen gemessen wird.

6. Siebdrucker nach Anspruch 5, wobei der Datenkorrekturabschnitt einen Filterverarbeitungsabschnitt aufweist, der eine in dem Druckdruck enthaltene anormale Variation basierend auf dem während des Siebdruckens mit einer Vielzahl von Wiederholungen gemessenen Druckdruck entfernt.

7. Siebdrucker nach Anspruch 5 oder 6, wobei der Datenkorrekturabschnitt die Steuerdaten basierend auf dem Produkt aus der Differenz zwischen dem durchschnittlichen Wert des Druckdrucks, der während des Siebdruckens mit einer Vielzahl von Wiederholungen gemessen wird, und dem Zielwert und aus einem auf weniger als eins gesetzten Koeffizienten korrigiert.

8. Siebdrucker nach einem der Ansprüche 1 bis 7, wobei:
der Siebdrucker das Paar von Druckrakeln aufweist, die einander in der Schieberichtung während des Siebdruckens gegenüberliegen, und
der Drucksteuerabschnitt das Siebdrucken basierend auf den Steuerdaten steuert, die in jeder aus dem Paar von Druckrakeln gemessen werden.

9. Siebdrucker nach Anspruch 8, wobei der Datenkorrekturabschnitt basierend auf Steuerinversionsdaten, die durch das Invertieren von für eine aus dem Paar von Rakeln gesetzten Steuerdaten erzeugt werden, die Steuerdaten der anderen aus dem Paar von Druckrakeln korrigiert.

10. Siebdrucker nach einem der Ansprüche 1 bis 9, wobei der Datenkorrekturabschnitt die Steuerdaten basierend auf der Druckumgebung, die die Form der Leiterplatte, die Biegesteifigkeit der Leiterplatte und/oder den Haltezustand in dem Siebdrucker umfasst, korrigiert.

## Revendications

1. Imprimante de sérigraphie qui comporte une raclette qui fait varier la force de pression pendant l'opération d'impression en fonction d'une valeur de commande, et qui effectue la sérigraphie avec pâte à braser en faisant glisser la raclette sur un masque placé dans la zone d'impression d'une carte de circuit, comprenant:
un capteur de pression qui mesure la pression d'impression appliquée sur la carte de circuit pendant l'opération d'impression par la raclette en fonction de la force de pression; et
une section de commande d'impression,
**caractérisée par**
une section de correction de données qui corrige les données de commande qui illustrent la relation entre la position de la raclette et une valeur de commande dans au moins une région de la zone d'impression sur la base de la relation entre la position de la raclette et la pression d'impression mesurée sur l'intégralité de la zone et une valeur cible de la pression d'impression qui est définie à l'avance, dans laquelle
la section de commande d'impression commande la sérigraphie en fonction des données de commande corrigées.

2. Imprimante de sérigraphie selon la revendication 1, dans laquelle la section de correction de données corrige les données de contrôle en fonction de l'impression de données d'inversion de pression qui reflètent la pression d'impression qui est mesurée sur la totalité de la zone inversée par rapport à la valeur cible.

3. Imprimante de sérigraphie selon les revendications 1 ou 2, dans laquelle la section de correction de données corrige les données de commande en fonction d'une caractéristique d'impression qui illustre le degré de variation de la pression d'impression par rapport au degré de correction de la valeur de commande.

4. Imprimante de sérigraphie selon l'une quelconque des revendications 1 à 3,
dans laquelle la section de commande d'impression exécute une commande de rétroaction pendant l'exécution de la sérigraphie dans laquelle la valeur de commande est corrigée de sorte que la pression d'impression mesurée est comprise dans une plage admissible par rapport à la valeur cible, et
la section de correction de données corrige les données de commande en fonction de l'écart entre la valeur de commande dans les données de commande et la valeur de correction de la valeur de commande dans la commande de rétroaction.

5. Imprimante de sérigraphie selon l'une quelconque des revendications 1 à 4, dans laquelle la section de correction de données corrige les données de commande en fonction de la pression d'impression mesurée lors de la sérigraphie à plusieurs reprises.

6. Imprimante de sérigraphie selon la revendication 5, dans laquelle la section de correction de données possède une section de traitement de filtrage qui supprime les variations anormales incluses dans la pression d'impression en fonction de la pression d'impression qui est mesurée pendant la sérigraphie à plusieurs reprises.

7. Imprimante de sérigraphie selon les revendications 5 ou 6, dans laquelle la section de correction de données corrige les données de contrôle en fonction d'un produit de la différence entre la valeur moyenne de la pression d'impression mesurée pendant la sérigraphie à plusieurs reprises et la valeur cible, et un coefficient dont la valeur fixée est inférieure à un.

8. Imprimante de sérigraphie selon l'une quelconque des revendications 1 à 7,
dans lequel l'imprimante de sérigraphie possède la paire de raclettes d'impression qui sont opposées l'une à l'autre dans le sens du glissement pendant la sérigraphie, et
la section de commande d'impression commande la sérigraphie en fonction des données de commande qui sont mesurées dans chacune des deux raclettes d'impression.

9. Imprimante de sérigraphie selon la revendication 8, dans laquelle la section de correction de données corrige, en fonction des données d'inversion de commande générées par l'inversion des données de commande définies pour l'une des paires de raclettes d'impression, les données de commande de l'autre de la paire de raclettes d'impression.

10. Imprimante de sérigraphie selon l'une quelconque des revendications 1 à 9, dans laquelle la section de correction de données corrige les données de commande en fonction de l'environnement d'impression qui comprend au moins un élément parmi la forme de la carte de circuit, la rigidité à la flexion de la carte de circuit et l'état de maintien dans l'imprimante de sérigraphie.
